# EUROPEAN PATENT APPLICATION

(11) **EP 1 640 952 A2**
(43) Date of publication of application: **29.03.2006**
(21) Application number: 05255656.0
(22) Date of filing: 14.09.2005
(51) Int. Cl.: G09G 3/34

(54) **System and method for transmitting video data**

(30) Priority: 27.09.2004 US 613494 P; 01.04.2005 US 97818
(71) Applicant: IDC, LLC, San Francisco, CA 94107 (US)
(72) Inventor: Sampsell, Jeffrey B., San Jose, California 95110 (US)
(74) Representative: Dunlop, Hugh Christopher

(57) **Abstract**

One embodiment comprises a system and method of transmitting video data to an array driver bypassing a processor, e.g., a central processing unit. In one embodiment, the transmitted data that bypasses the processor is targeted for display in a particular region of the display. In one embodiment, the size, location, and refresh rate of region is definable by a server or the processor, e.g., application software executing on the processor. In another embodiment, the processor has two communication paths for transmitting video to a display array. The first communication path connects the processor to an array driver. The second communication path connects the processor to a driver controller. In one embodiment, the data that is transmitted to each of the paths targeted for presentation on a selected region of the display. In one embodiment, the size, location, and refresh rate of each of the regions is definable by a server or the processor, e.g., application software executing on the processor.

## Description

### Background

### Field of the Invention

The field of the invention relates to microelectromechanical systems (MEMS).

### Description of the Related Technology

Microelectromechanical systems (MEMS) include micro mechanical elements, actuators, and electronics. Micromechanical elements may be created using deposition, etching, and or other micromachining processes that etch away parts of substrates and/or deposited material layers or that add layers to form electrical and electromechanical devices. One type of MEMS device is called an interferometric modulator. An interferometric modulator may comprise a pair of conductive plates, one or both of which may be transparent and/or reflective in whole or part and capable of relative motion upon application of an appropriate electrical signal. One plate may comprise a stationary layer deposited on a substrate, the other plate may comprise a metallic membrane separated from the stationary layer by an air gap. Such devices have a wide range of applications, and it would be beneficial in the art to utilize and/or modify the characteristics of these types of devices so that their features can be exploited in improving existing products and creating new products that have not yet been developed.

### Summary of Certain Embodiments

The system, method, and devices of the invention each have several aspects, no single one of which is solely responsible for its desirable attributes. Without limiting the scope of this invention, its more prominent features will now be discussed briefly. After considering this discussion, and particularly after reading the section entitled "Detailed Description of Certain Embodiments" one will understand how the features of this invention provide advantages over other display devices.

One embodiment comprises a system having an array of bi-stable display elements. The array may be logically partitioned into at least a first group of bi-stable display elements and a second group of bi-stable display elements. An array driver is provided to control the bi-stable display elements. Furthermore, a central processing unit is provided to transmit video data to the array driver for display via the first group of bi-stable display elements. In one embodiment, a network interface is configured to receive video data and control information. The network interface is configured to determine, based upon the control information, whether to transmit the video data to the array driver for display or whether to transmit the video data to the central processing unit. The video data that is transmitted to the array driver directly from the network interface is displayed via the second group of bi-stable display elements.

Another embodiment comprises a method of displaying video data. The method comprises receiving, in an electronic device, video data from a network; and determining whether to transmit the video data directly to an array driver or to a processor.

Yet another embodiment comprises a method of displaying video data. The method comprises receiving, in an electronic device, video data from a network; and transmitting, independently of a central processing unit in the electronic device, the video data to an array driver in the electronic device.

Yet another embodiment comprises a system for displaying video data. The system comprises means for receiving video data from a network; and means for transmitting, independently of a central processing unit in the electronic device, the video data directly to an array driver in the electronic device.

Yet another embodiment comprises a system having an array of bi-stable display elements and an array driver configured to control the bi-stable display elements. The system also comprises a serial bus configured to transmit data to the array driver for display via a first portion of the bi-stable display elements and a parallel bus configured to transmit data to the array driver for display via a second portion of the bi-stable display elements. A central processing unit is provided to receive video data and control information. The central processing unit is configured to determine, based upon the control information, whether to transmit the video data to the array driver via the serial bus or the parallel bus.

Yet another embodiment comprises a method of displaying video data. The method comprises receiving, in an electronic device, video data from a network, and determining whether to transmit the video data to an array driver in the electronic device via either a serial or a parallel bus.

Yet another embodiment comprises device configured to display video data. The device comprises a receiver configured to receive video data; and a network interface configured to determine whether to transmit the video data directly b an array driver or to a processor.

Yet another embodiment comprises a system of displaying video data. The system comprises means for receiving video data from a network, and means for determining whether to transmit the video data to the array driver or to a processor.

Yet another embodiment comprises a method of manufacturing a display system. The method comprises providing an array of bi-stable display elements, the array being logically partitioned into at least a first group of bi-stable display elements and a second group of bi-stable display elements. An array driver is connected to the array driver, the array driver being configured to control the bi-stable display elements. A central processing unit is provided that is configured to transmit video data to the array driver for display via the first group of bi-stable display elements. A network interface is also provided that is configured to receive video data and control information, the network interface being configured to determine, based upon the control information, whether to transmit the video data to the array driver for display or to the central processing unit, wherein the video data that is transmitted to the array driver directly from the network interface is displayed via the second group of bi-stable display elements.

### Brief Description of the Drawings

Figure 1 illustrates a networked system of one embodiment.
Figure 2 is an isometric view depicting a portion of one embodiment of an interferometric modulator display array in which a movable reflective layer of a first interferometric modulator is in a released position and a movable reflective layer of a second interferometric modulator is in an actuated position.
Figure 3A is a system block diagram illustrating one embodiment of an electronic device incorporating a 3x3 interferometric modulator display array.
Figure 3B is an illustration of an embodiment of a client of the server-based wireless network service of Figure 1.
Figure 3C is an exemplary block diagram configuration of the client in Figure 3B.
Figure 4A is a diagram of movable mirror position versus applied voltage for one exemplary embodiment of an interferometric modulator of Figure 2.
Figure 4B is an illustration of a set of row and column voltages that may be used to drive an interferometric modulator display array.
Figures 5A and 5B illustrate one exemplary timing diagram for row and column signals that may be used to write a frame of data to the 3x3 interferometric modulator display array of Figure 3A.
Figure 6A is a cross section of the interferometric modulator of Figure 2.
Figure 6B is a cross section of an alternative embodiment of an interferometric modulator.
Figure 6C is a cross section of another alternative embodiment of an interferometric modulator.
Figure 7 is a high level flowchart of a client control process.
Figure 8 is a flowchart of a client control process for launching and running a receive/display process.
Figure 9 is a flowchart of a server control process for sending video data to a client.
Figure 10 is a flowchart illustrating an exemplary method of receiving and processing data in the processor of Figure 3A.
Figure 11 is a flowchart illustrating an exemplary method of receiving and processing data in the network interface of Figure 3A.

### Detailed Description of Certain Embodiments

The following detailed description is directed to certain specific embodiments. However, the invention can be embodied in a multitude of different ways. Reference in this specification to "one embodiment" or "an embodiment" means that a particular feature, structure, or characteristic described in connection with the embodiment is included in at least one embodiment. The appearances of the phrase "in one embodiment," "according to one embodiment," or "in some embodiments" in various places in the specification are not necessarily all referring to the same embodiment, nor are separate or alternative embodiments mutually exclusive of other embodiments. Moreover, various features are described which may be exhibited by some embodiments and not by others. Similarly, various requirements are described which may be requirements for some embodiments but not other embodiments.

In one embodiment, a display array on a device includes at least one driving circuit and an array of means, e.g., interferometric modulators, on which video data is displayed. Video data, as used herein, refers to any kind of displayable data, including pictures, graphics, and words, displayable in either static or dynamic images (for example, a series of video frames that when viewed give the appearance of movement, e.g., a continuous ever-changing display of stock quotes, a "video clip", or data indicating the occurrence of an event of action). Video data, as used herein, also refers to any kind of control data, including instructions on how the video data is to be processed (display mode), such as frame rate, and data format. The array is driven by the driving circuit to display video data.

One embodiment comprises a system and method of transmitting video data to an array driver, bypassing a processor, e.g., a central processing unit. In one embodiment, the transmitted data that bypasses the processor is targeted for display in a particular region of the display. In one embodiment, the size, location, and refresh rate of a region is definable by a server or the processor, e.g., application software executing on the processor. In another embodiment, the processor has two communication paths for transmitting video to a display array. The first communication path connects the processor to an array driver. The second communication path connects the processor to a driver controller. In one embodiment, the data that is transmitted by each path is targeted for presentation on a respective selected region of the display. In one embodiment, the size, location, and refresh rate of each of the regions is definable by a server or the processor, e.g., application software executing on the processor.

In this description, reference is made to the drawings wherein like parts are designated with like numerals throughout. The invention may be implemented in any device that is configured to display an image, whether in motion (e.g., video) or stationary (e.g., still image), and whether textual or pictorial. More particularly, it is contemplated that the invention may be implemented in or associated with a variety of electronic devices such as, but not limited to, mobile telephones, wireless devices, personal data assistants (PDAs), hand-held or portable computers, GPS receivers/navigators, cameras, MP3 players, camcorders, game consoles, wrist watches, clocks, calculators, television monitors, flat panel displays, computer monitors, auto displays (e.g., odometer display, etc.), cockpit controls and/or displays, display of camera views (e.g., display of a rear view camera in a vehicle), electronic photographs, electronic billboards or signs, projectors, architectural structures, packaging, and aesthetic structures (e.g., display of images on a piece of jewelry). MEMS devices of similar structure to those described herein can also be used in non-display applications such as in electronic switching devices.

Spatial light modulators used for imaging applications come in many different forms. Transmissive liquid crystal display (LCD) modulators modulate light by controlling the twist and/or alignment of crystalline materials to block or pass light. Reflective spatial light modulators exploit various physical effects to control the amount of light reflected to the imaging surface. Examples of such reflective modulators include reflective LCDs, and digital micromirror devices.

Another example of a spatial light modulator is an interferometric modulator that modulates light by interference. Interferometric modulators are bi-stable display elements which employ a resonant optical cavity having at least one movable or deflectable wall. Constructive interference in the optical cavity determines the color of the viewable light emerging from the cavity. As the movable wall, typically comprised at least partially of metal, moves towards the stationary front surface of the cavity, the interference of light within the cavity is modulated, and that modulation affects the color of light emerging at the front surface of the modulator. The front surface is typically the surface where the image seen by the viewer appears, in the case where the interferometric modulator is a direct-view device.

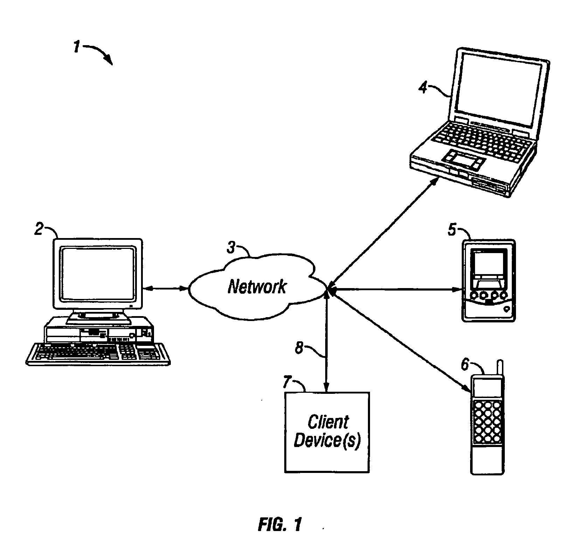

Figure 1 illustrates a networked system in accordance with one embodiment. A server 2, such as a Web server is operatively coupled to a network 3. The server 2 can correspond to a Web server, to a cell-phone server, to a wireless e-mail server, and the like. The network 3 can include wired networks, or wireless networks, such as WiFi networks, cell-phone networks, Bluetooth networks, and the like.

The network 3 can be operatively coupled to a broad variety of devices. Examples of devices that can be coupled to the network 3 include a computer such as a laptop computer 4, a personal digital assistant (PDA) 5, which can include wireless handheld devices such as the BlackBerry, a Palm Pilot, a Pocket PC, and the like, and a cell phone 6, such as a Web-enabled cell phone, Smartphone, and the like. Many other devices can be used, such as desk-top PCs, set-top boxes, digital media players, handheld PCs, Global Positioning System (GPS) navigation devices, automotive displays, or other stationary and mobile displays. For convenience of discussion all of these devices are collectively referred to herein as the client device 7.

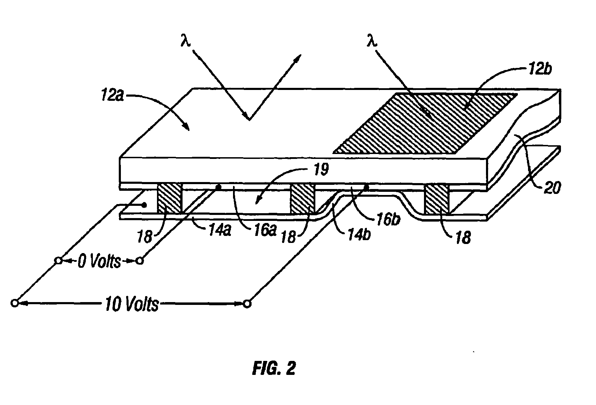

One bi-stable display element embodiment comprising an interferometric MEMS display element is illustrated in Figure 2. In these devices, the pixels are in either a bright or dark state. In the bright ("on" or "open") state, the display element reflects a large portion of incident visible light to a user. When in the dark ("off" or "closed") state, the display element reflects little incident visible light to the user. Depending on the embodiment, the light reflectance properties of the "on" and "off" states may be reversed. MEMS pixels can be configured to reflect predominantly at selected colors, allowing for a color display in addition to black and white.

Figure 2 is an isometric view depicting two adjacent pixels in a series of pixels of a visual display array, wherein each pixel comprises a MEMS interferometric modulator. In some embodiments, an interferometric modulator display array comprises a row/column array of these interferometric modulators. Each interferometric modulator includes a pair of reflective layers positioned at a variable and controllable distance from each other to form a resonant optical cavity with at least one variable dimension. In one embodiment, one of the reflective layers may be moved between two positions. In the first position, referred to herein as the released state, the movable layer is positioned at a relatively large distance from a fixed partially reflective layer. In the second position, the movable layer is positioned more closely adjacent to the partially reflective layer. Incident light that reflects from the two layers interferes constructively or destructively depending on the position of the movable reflective layer, producing either an overall reflective or non-reflective state for each pixel.

The depicted portion of the pixel array in Figure 2 includes two adjacent interferometric modulators 12a and 12b. In the interferometric modulator 12a on the left, a movable and highly reflective layer 14a is illustrated in a released position at a predetermined distance from a fixed partially reflective layer 16a. In the interferometric modulator 12b on the right, the movable highly reflective layer 14b is illustrated in an actuated position adjacent to the fixed partially reflective layer 16b.

The partially reflective layers 16a, 16b are electrically conductive, partially transparent and fixed, and may be fabricated, for example, by depositing one or more layers each of chromium and indium-tin-oxide onto a transparent substrate 20. The layers are patterned into parallel strips, and may form row electrodes in a display device as described further below. The highly reflective layers 14a, 14b may be formed as a series of parallel strips of a deposited metal layer or layers (orthogonal to the row electrodes, partially reflective layers 16a, 16b) deposited on top of supports 18 and an intervening sacrificial material deposited between the supports 18. When the sacrificial material is etched away, the deformable metal layers are separated from the fixed metal layers by a defined air gap 19. A highly conductive and reflective material such as aluminum may be used for the deformable layers, and these strips may form column electrodes in a display device.

With no applied voltage, the air gap 19 remains between the layers 14a, 16a and the deformable layer is in a mechanically relaxed state as illustrated by the interferometric modulator 12a in Figure 2. However, when a potential difference is applied to a selected row and column, the capacitor formed at the intersection of the row and column electrodes at the corresponding pixel becomes charged, and electrostatic forces pull the electrodes together. If the voltage is high enough, the movable layer is deformed and is forced against the fixed layer (a dielectric material which is not illustrated in this Figure may be deposited on the fixed layer to prevent shorting and control the separation distance) as illustrated by the interferometric modulator 12b on the right in Figure 2. The behavior is the same regardless of the polarity of the applied potential difference. In this way, row/column actuation that can control the reflective vs. non-reflective interferometric modulator states is analogous in many ways to that used in conventional LCD and other display technologies.

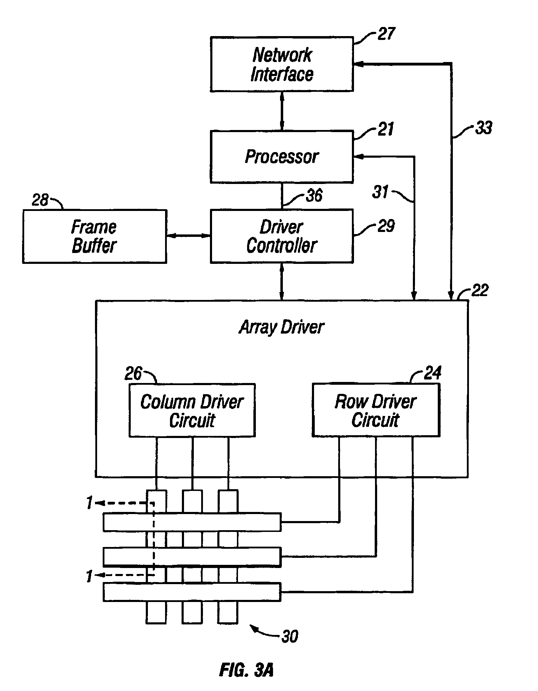

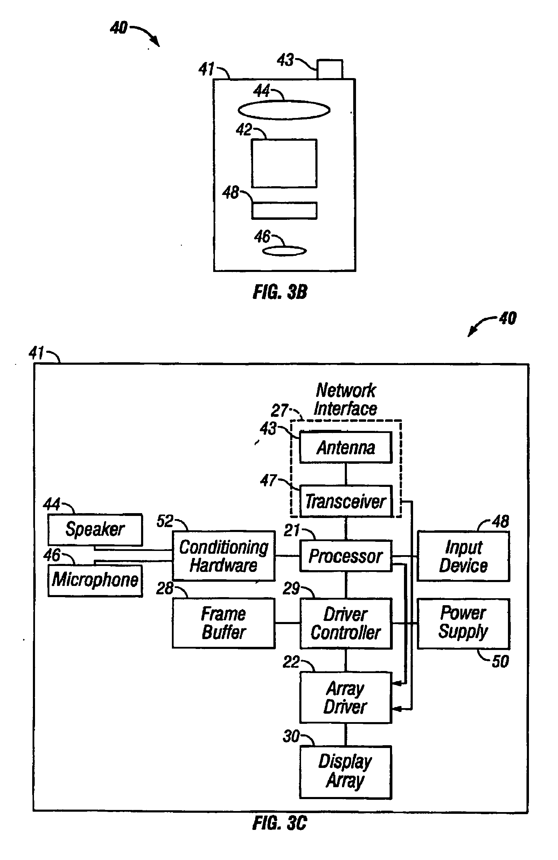

Figures 3 through 5 illustrate an exemplary process and system for using an array of interferometric modulators in a display application. However, the process and system can also be applied to other displays, e.g., plasma, EL, OLED, STN LCD, and TFT LCD.

Currently, available flat panel display controllers and drivers have been designed to work almost exclusively with displays that need to be constantly refreshed. Thus, the image displayed on plasma, EL, OLED, STN LCD, and TFT LCD panels, for example, will disappear in a fraction of a second if not refreshed many times within a second. However, because interferometric modulators of the type described above have the ability to hold their state for a longer period of time without refresh, wherein the state of the interferometric modulators may be maintained in either of two states without refreshing, a display that uses interferometric modulators may be referred to as a bi-stable display. In one embodiment, the state of the pixel elements is maintained by applying a bias voltage, sometimes referred to as a latch voltage, to the one or more interferometric modulators that comprise the pixel element.

In general, a display device typically requires one or more controllers and driver circuits for proper control of the display device. Driver circuits, such as those used to drive LCD's, for example, may be bonded directly to, and situated along the edge of the display panel itself. Alternatively, driver circuits may be mounted on flexible circuit elements connecting the display panel (at its edge) to the rest of an electronic system. In either case, the drivers are typically located at the interface of the display panel and the remainder of the electronic system.

Figure 3A is a system block diagram illustrating some embodiments of an electronic device that can incorporate various aspects. In the exemplary embodiment, the electronic device includes a processor 21 which may be any general purpose single- or multi-chip microprocessor such as an ARM, Pentium®, Pentium II® , Pentium III® , Pentium IV®, Pentium® Pro, an 8051, a MIPS® , a Power PC® , an ALPHA® , or any special purpose microprocessor such as a digital signal processor, microcontroller, or a programmable gate array. As is conventional in the art, the processor 21 may be configured to execute one or more software modules. In addition to executing an operating system, the processor may be configured to execute one or more software applications, including a web browser, a telephone application, an email program, or any other software application.

Figure 3A illustrates an embodiment of electronic device that includes a network interface 27 connected to a processor 21 and, according to some embodiments, the network interface can be connected to an array driver 22. The network interface 27 includes the appropriate hardware and software so that the device can interact with another device over a network, for example, the server 2 shown in Figure 1. The processor 21 is connected to driver controller 29 which is connected to an array driver 22 and to frame buffer 28. In some embodiments, the processor 21 is also connected to the array driver 22. The array driver 22 is connected to and drives the display array 30. The components illustrated in Figure 3A illustrate a configuration of an interferometric modulator display. However, this configuration can also be used in a LCD with an LCD controller and driver. As illustrated in Figure 3A, the driver controller 29 is connected to the processor 21 via a parallel bus 36. Although a driver controller 29, such as a LCD controller, is often associated with the system processor 21, as a stand-alone Integrated Circuit (IC), such controllers may be implemented in many ways. They may be embedded in the processor 21 as hardware, embedded in the processor 21 as software, or fully integrated in hardware with the array driver 22. In one embodiment, the driver controller 29 takes the display information generated by the processor 21, reformats that information appropriately for high speed transmission to the display array 30, and sends the formatted information to the array driver 22.

The array driver 22 receives the formatted information from the driver controller 29 and reformats the video data into a parallel set of waveforms that are applied many times per second to the hundreds and sometimes thousands of leads coming from the display's x-y matrix of pixels. The currently available flat panel display controllers and drivers such as those described immediately above have been designed to work almost exclusively with displays that need to be constantly refreshed. Because bi-stable displays (e.g., an array of interferometric modulators) do not require such constant refreshing, features that decrease power requirements may be realized through the use of bi-stable displays. However, if bi-stable displays are operated by the controllers and drivers that are used with current displays the advantages of a bi-stable display may not be optimized. Thus, improved controller and driver systems and methods for use with bi-stable displays are desired. For high speed bi-stable displays, such as the interferometric modulators described above, these improved controllers and drivers preferably implement low-refresh-rate modes, video rate refresh modes, and unique modes to facilitate the unique capabilities of bi-stable modulators. According to the methods and systems described herein, a bi-stable display may be configured to reduce power requirements in various manners.

In one embodiment illustrated by Figure 3A, the array driver 22 receives video data from the processor 21 via a data link 31 bypassing the driver controller 29. The data link 31 may comprise a serial peripheral interface ("SPI"), I²C bus, parallel bus, or any other available interface. In one embodiment shown in Figure 3A, the processor 21 provides instructions to the array driver 22 that allow the array driver 22 to optimize the power requirements of the display array 30 (e.g., an interferometric modulator display). In one embodiment, video data intended for a portion of the display, such as for example defined by the server 2, can be identified by data packet header information and transmitted via the data link 31. In addition, the processor 21 can route primitives, such as graphical primitives, along data link 31 to the array driver 22. These graphical primitives can correspond to instructions such as primitives for drawing shapes and text.

Still referring to Figure 3A, in one embodiment, video data may be provided from the network interface 27 to the array driver 22 via data link 33. In one embodiment, the network interface 27 analyzes control information that is transmitted from the server 2 and determines whether the incoming video should be routed to either the processor 21 or, alternatively, the array driver 22.

In one embodiment, video data provided by data link 33 is not stored in the frame buffer 28, as is usually the case in many embodiments. It will also be understood that in some embodiments, a second driver controller (not shown) can also be used to render video data for the array driver 22. The data link 33 may comprise a SPI, I²C bus, or any other available interface. The array driver 22 can also include address decoding, row and column drivers for the display and the like. The network interface 27 can also provide video data directly to the array driver 22 at least partially in response to instructions embedded within the video data provided to the network interface 27. It will be understood by the skilled practitioner that arbiter logic can be used to control access by the network interface 27 and the processor 21 to prevent data collisions at the array driver 22. In one embodiment, a driver executing on the processor 21 controls the timing of data transfer from the network interface 27 to the array driver 22 by permitting the data transfer during time intervals that are typically unused by the processor 21, such as time intervals traditionally used for vertical blanking delays and/or horizontal blanking delays.

Advantageously, this design permits the server 2 to bypass the processor 21 and the driver controller 29, and to directly address a portion of the display array 30. For example, in the illustrated embodiment, this permits the server 2 to directly address a predefined display array area of the display array 30. In one embodiment, the amount of data communicated between the network interface 27 and the array driver 22 is relatively low and is communicated using a serial bus, such as an Inter-Integrated Circuit (I²C) bus or a Serial Peripheral Interface (SPI) bus. It will also be understood, however, that where other types of displays are utilized, that other circuits will typically also be used. The video data provided via data link 33 can advantageously be displayed without a frame buffer 28 and with little or no intervention from the processor 21.

Figure 3A also illustrates a configuration of a processor 21 coupled to a driver controller 29, such as an interferometric modulator controller. The driver controller 29 is coupled to the array driver 22, which is connected to the display array 30. In this embodiment, the driver controller 29 accounts for the display array 30 optimizations and provides information to the array driver 22 without the need for a separate connection between the array driver 22 and the processor 21. In some embodiments, the processor 21 can be configured to communicate with a driver controller 29, which can include a frame buffer 28 for temporary storage of one or more frames of video data.

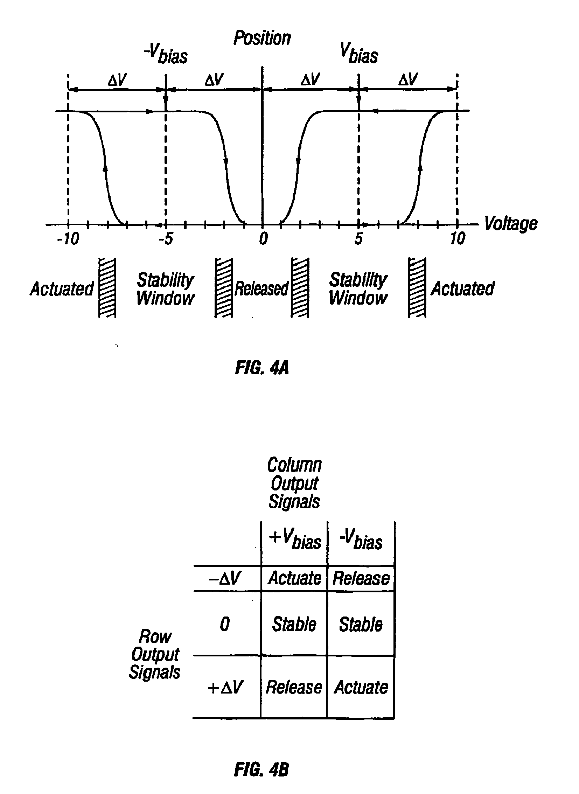

As shown in Figure 3A, in one embodiment the array driver 22 includes a row driver circuit 24 and a column driver circuit 26 that provide signals to a pixel display array 30. The cross section of the array illustrated in Figure 2 is shown by the lines 1-1 in Figure 3A. For MEMS interferometric modulators, the row/column actuation protocol may take advantage of a hysteresis property of these devices illustrated in Figure 4A. It may require, for example, a 10 volt potential difference to cause a movable layer to deform from the released state to the actuated state. However, when the voltage is reduced from that value, the movable layer maintains its state as the voltage drops back below 10 volts. In the exemplary embodiment of Figure 4A, the movable layer does not release completely until the voltage drops below 2 volts. There is thus a range of voltage, about 3 to 7 V in the example illustrated in Figure 4A, where there exists a window of applied voltage within which the device is stable in either the released or actuated state. This is referred to herein as the "hysteresis window" or "stability window."

For a display array having the hysteresis characteristics of Figure 4A, the row/column actuation protocol can be designed such that during row strobing, pixels in the strobed row that are to be actuated are exposed to a voltage difference of about 10 volts, and pixels that are to be released are exposed to a voltage difference of close to zero volts. After the strobe, the pixels are exposed to a steady state voltage difference of about 5 volts such that they remain in whatever state the row strobe put them in. After being written, each pixel sees a potential difference within the "stability window" of 3-7 volts in this example. This feature makes the pixel design illustrated in Figure 2 stable under the same applied voltage conditions in either an actuated or released pre-existing state. Since each pixel of the interferometric modulator, whether in the actuated or released state, is essentially a capacitor formed by the fixed and moving reflective layers, this stable state can be held at a voltage within the hysteresis window with almost no power dissipation. Essentially no current flows into the pixel if the applied potential is fixed.

In typical applications, a display frame may be created by asserting the set of column electrodes in accordance with the desired set of actuated pixels in the first row. A row pulse is then applied to the row 1 electrode, actuating the pixels corresponding to the asserted column lines. The asserted set of column electrodes is then changed to correspond to the desired set of actuated pixels in the second row. A pulse is then applied to the row 2 electrode, actuating the appropriate pixels in row 2 in accordance with the asserted column electrodes. The row 1 pixels are unaffected by the row 2 pulse, and remain in the state they were set to during the row 1 pulse. This may be repeated for the entire series of rows in a sequential fashion to produce the frame. Generally, the frames are refreshed and/or updated with new video data by continually repeating this process at some desired number of frames per second. A wide variety of protocols for driving row and column electrodes of pixel arrays to produce display array frames are also well known and may be used.

One embodiment of a client device 7 is illustrated in Figure 3B. The exemplary client 40 includes a housing 41, a display 42, an antenna 43, a speaker 44, an input device 48, and a microphone 46. The housing 41 is generally formed from any of a variety of manufacturing processes as are well known to those of skill in the art, including injection molding, and vacuum forming. In addition, the housing 41 may be made from any of a variety of materials, including but not limited to plastic, metal, glass, rubber, and ceramic, or a combination thereof. In one embodiment the housing 41 includes removable portions (not shown) that may be interchanged with other removable portions of different color, or containing different logos, pictures, or symbols.

The display 42 of exemplary client 40 may be any of a variety of displays, including a bi-stable display, as described herein with respect to, for example, Figures 2, 3A, and 4-6. In other embodiments, the display 42 includes a flat-panel display, such as plasma, EL, OLED, STN LCD, or TFT LCD as described above, or a non-flat-panel display, such as a CRT or other tube device, as is well known to those of skill in the art. However, for purposes of describing the present embodiment, the display 42 includes an interferometric modulator display, as described herein.

The components of one embodiment of exemplary client 40 are schematically illustrated in Figure 3C. The illustrated exemplary client 40 includes a housing 41 and can include additional components at least partially enclosed therein. For example, in one embodiment, the client exemplary 40 includes a network interface 27 that includes an antenna 43 which is coupled to a transceiver 47. The transceiver 47 is connected to a processor 21, which is connected to conditioning hardware 52. The conditioning hardware 52 is connected to a speaker 44 and a microphone 46. The processor 21 is also connected to an input device 48 and a driver controller 29. The driver controller 29 is coupled to a frame buffer 28, and to an array driver 22, which in turn is coupled to a display array 30. A power supply 50 provides power to all components as required by the particular exemplary client 40 design.

The network interface 27 includes the antenna 43, and the transceiver 47 so that the exemplary client 40 can communicate with another device over a network 3, for example, the server 2 shown in Figure 1. In one embodiment the network interface 27 may also have some processing capabilities to relieve requirements of the processor 21. The antenna 43 is any antenna known to those of skill in the art for transmitting and receiving signals. In one embodiment, the antenna transmits and receives RF signals according to the IEEE 802.11 standard, including IEEE 802.11(a), (b), or (g). In another embodiment, the antenna transmits and receives RF signals according to the BLUETOOTH standard. In the case of a cellular telephone, the antenna is designed to receive CDMA, GSM, AMPS or other known signals that are used to communicate within a wireless cell phone network. The transceiver 47 pre-processes the signals received from the antenna 43 so that they may be received by and further processed by the processor 21. The transceiver 47 also processes signals received from the processor 21 so that they may be transmitted from the exemplary client 40 via the antenna 43.

Processor 21 generally controls the overall operation of the exemplary client 40, although operational control may be shared with or given to the server 2 (not shown), as will be described in greater detail below. In one embodiment, the processor 21 includes a microcontroller, CPU, or logic unit to control operation of the exemplary client 40. Conditioning hardware 52 generally includes amplifiers and filters for transmitting signals to the speaker 44, and for receiving signals from the microphone 46. Conditioning hardware 52 may be discrete components within the exemplary client 40, or may be incorporated within the processor 21 or other components.

The input device 48 allows a user to control the operation of the exemplary client 40. In one embodiment, input device 48 includes a keypad, such as a QWERTY keyboard or a telephone keypad, a button, a switch, a touch-sensitive screen, a pressure- or heat-sensitive membrane. In one embodiment, a microphone is an input device for the exemplary client 40. When a microphone is used to input data to the device, voice commands may be provided by a user for controlling operations of the exemplary client 40.

In one embodiment, the driver controller 29, array driver 22, and display array 30 are appropriate for any of the types of displays described herein. For example, in one embodiment, driver controller 29 is a conventional display controller or a bi-stable display controller (e.g., an interferometric modulator controller). In another embodiment, array driver 22 is a conventional driver or a bi-stable display driver (e.g., a interferometric modulator display). In yet another embodiment, display array 30 is a typical display array or a bi-stable display array (e.g., a display including an array of interferometric modulators).

Power supply 50 is any of a variety of energy storage devices as are well known in the art. For example, in one embodiment, power supply 50 is a rechargeable battery, such as a nickelcadmium battery or a lithium ion battery. In another embodiment, power supply 50 is a renewable energy source, a capacitor, or a solar cell, including a plastic solar cell, and solar-cell paint. In another embodiment, power supply 50 is configured to receive power from a wall outlet.

In one embodiment, the array driver 22 contains a register that may be set to a predefined value to indicate that the input video stream is in an interlaced format and should be displayed on the bi-stable display in an interlaced format, without converting the video stream to a progressive scanned format. In this way the bi-stable display does not require interlace-to-progressive scan conversion of interlace video data.

In some implementations control programmability resides, as described above, in a display controller which can be located in several places in the electronic display system. In some cases control programmability resides in the array driver 22 located at the interface between the electronic display system and the display component itself. Those of skill in the art will recognize that the above-described optimization may be implemented in any number of hardware and/or software components and in various configurations.

In one embodiment, circuitry is embedded in the array driver 22 to take advantage of the fact that the output signal set of most graphics controllers includes a signal to delineate the horizontal active area of the display array 30 being addressed. This horizontal active area can be changed via register settings in the driver controller 29. These register settings can be changed by the processor 21. This signal is usually designated as display enable (DE). Most all display video interfaces in addition utilize a line pulse (LP) or a horizontal synchronization (HSYNC) signal, which indicates the end of a line of data. A circuit which counts LPs can determine the vertical position of the current row. When refresh signals are conditioned upon the DE from the processor 21 (signaling for a horizontal region), and upon the LP counter circuit (signaling for a vertical region) an area update function can be implemented.

In one embodiment, a driver controller 29 is integrated with the array driver 22. Such an embodiment is common in highly integrated systems such as cellular phones, watches, and other small area displays. Specialized circuitry within such an integrated array driver 22 first determines which pixels and hence rows require refresh, and only selects those rows that have pixels that have changed to update. With such circuitry, particular rows can be addressed in non-sequential order, on a changing basis depending on image content. This embodiment has the advantage that since only the changed video data needs to be sent through the interface, data rates can be reduced between the processor 21 and the display array 30. Lowering the effective data rate required between processor 21 and array driver 22 improves power consumption, noise immunity and electromagnetic interference issues for the system.

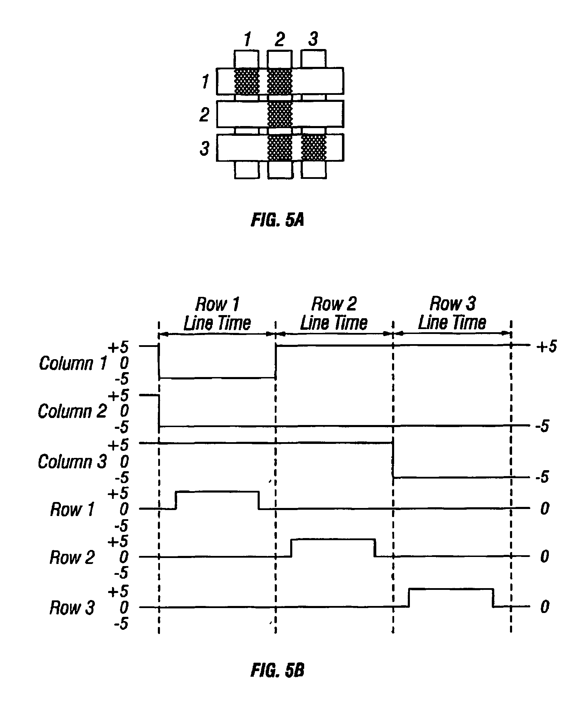

Figures 4 and 5 illustrate one possible actuation protocol for creating a display frame on the 3x3 array of Figure 3. Figure 4B illustrates a possible set of column and row voltage levels that may be used for pixels exhibiting the hysteresis curves of Figure 4A. In the Figure 4A/4B embodiment, actuating a pixel may involve setting the appropriate column to -V_{bias}, and the appropriate row to +ΔV, which may correspond to -5 volts and +5 volts respectively. Releasing the pixel may be accomplished by setting the appropriate column to +V_{bias}, and the appropriate row to the same +ΔV, producing a zero volt potential difference across the pixel. In those rows where the row voltage is held at zero volts, the pixels are stable in whatever state they were originally in, regardless of whether the column is at +V_{bias}, or -V_{bias}. Similarly, actuating a pixel may involve setting the appropriate column to +V_{bias}, and the appropriate row to -ΔV, which may correspond to 5 volts and -5 volts respectively. Releasing the pixel may be accomplished by setting the appropriate column to -V_{bias}, and the appropriate row to the same -ΔV, producing a zero volt potential difference across the pixel. In those rows where the row voltage is held at zero volts, the pixels are stable in whatever state they were originally in, regardless of whether the column is at +V_{bias}, or -V_{bias}.

Figure 5B is a timing diagram showing a series of row and column signals applied to the 3x3 array of Figure 3A which will result in the display arrangement illustrated in Figure 5A, where actuated pixels are non-reflective. Prior to writing the frame illustrated in Figure 5A, the pixels can be in any state, and in this example, all the rows are at 0 volts, and all the columns are at +5 volts. With these applied voltages, all pixels are stable in their existing actuated or released states.

In the Figure 5A frame, pixels (1,1), (1,2), (2,2), (3,2) and (3,3) are actuated. To accomplish this, during a "line time" for row 1, columns 1 and 2 are set to-5 volts, and column 3 is set to +5 volts. This does not change the state of any pixels, because all the pixels remain in the 3-7 volt stability window. Row 1 is then strobed with a pulse that goes from 0, up to 5 volts, and back to zero. This actuates the (1,1) and (1,2) pixels and releases the (1,3) pixel. No other pixels in the array are affected. To set row 2 as desired, column 2 is set to-5 volts, and columns 1 and 3 are set to +5 volts. The same strobe applied to row 2 will then actuate pixel (2,2) and release pixels (2,1) and (2,3). Again, no other pixels of the array are affected. Row 3 is similarly set by setting columns 2 and 3 to -5 volts, and column 1 to +5 volts. The row 3 strobe sets the row 3 pixels as shown in Figure 5A. After writing the frame, the row potentials are zero, and the column potentials can remain at either +5 or -5 volts, and the display is then stable in the arrangement of Figure 5A. It will be appreciated that the same procedure can be employed for arrays of dozens or hundreds of rows and columns. It will also be appreciated that the timing, sequence, and levels of voltages used to perform row and column actuation can be varied widely within the general principles outlined above, and the above example is exemplary only, and any actuation voltage method can be used.

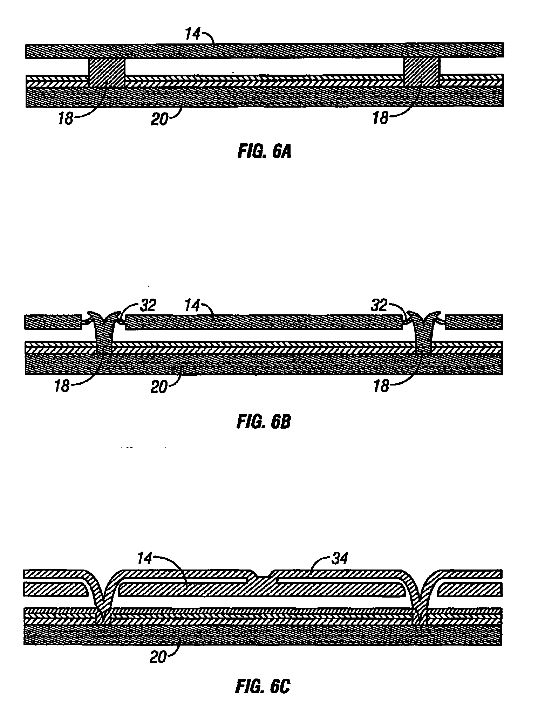

The details of the structure of interferometric modulators that operate in accordance with the principles set forth above may vary widely. For example, Figures 6A-6C illustrate three different embodiments of the moving mirror structure. Figure 6A is a cross section of the embodiment of Figure 2, where a strip of reflective material 14 is deposited on orthogonal supports 18. In Figure 6B, the reflective material 14 is attached to supports 18 at the corners only, on tethers 32. In Figure 6C, the reflective material 14 is suspended from a deformable layer 34. This embodiment has benefits because the structural design and materials used for the reflective material 14 can be optimized with respect to the optical properties, and the structural design and materials used for the deformable layer 34 can be optimized with respect to desired mechanical properties. The production of various types of interferometric devices is described in a variety of published documents, including, for example, U.S. Published Application 2004/0051929. A wide variety of well known techniques may be used to produce the above described structures involving a series of material deposition, patterning, and etching steps.

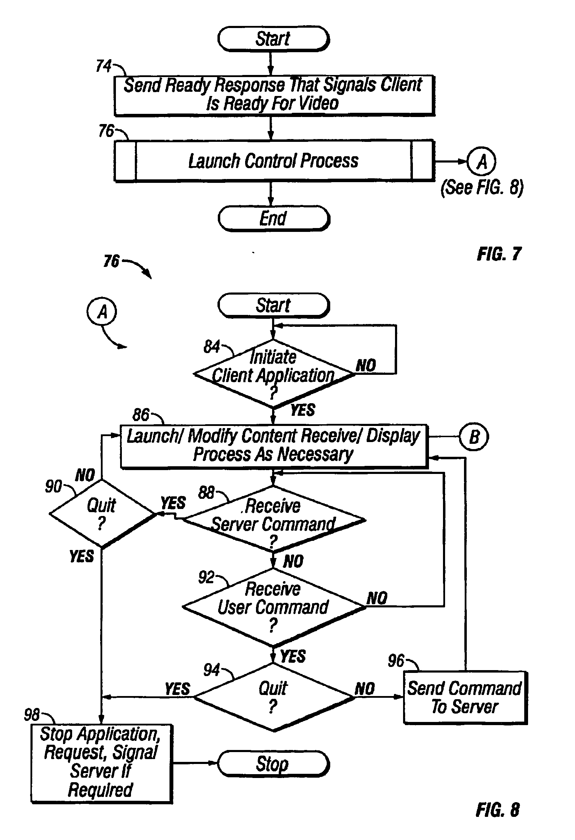

An embodiment of process flow is illustrated in Figure 7, which shows a high-level flowchart of a client device 7 control process. This flowchart describes the process used by a client device 7, such as a laptop computer 4, a PDA 5, or a cell phone 6, connected to a network 3, to graphically display video data, received from a server 2 via the network 3. Depending on the embodiment, states of Figure 7 can be removed, added, or rearranged.

Again referring to Figure 7, starting at state 74 the client device 7 sends a signal to the server 2 via the network 3 that indicates the client device 7 is ready for video. In one embodiment a user may start the process of Figure 7 by turning on an electronic device such as a cell phone. Continuing to state 76 the client device 7 launches its control process. An example of launching a control process is discussed further with reference to Figure 8.

An embodiment of process flow is illustrated in Figure 8, which shows a flowchart of a client device 7 control process for launching and running a control process. This flowchart illustrates in further detail state 76 discussed with reference to Figure 7. Depending on the embodiment, states of Figure 8 can be removed, added, or rearranged.

Starting at decision state 84, the client device 7 makes a determination whether an action at the client device 7 requires an application at the client device 7 to be started, or whether the server 2 has transmitted an application to the client device 7 for execution, or whether the server 2 has transmitted to the client device 7 a request to execute an application resident at the client device 7. If there is no need to launch an application the client device 7 remains at decision state 84. After starting an application, continuing to state 86, the client device 7 launches a process by which the client device 7 receives and displays video data. The video data may stream from the server 2, or may be downloaded to the client device 7 memory for later access. The video data can be video, or a still image, or textual or pictorial information. The video data can also have various compression encodings, and be interlaced or progressively scanned, and have various and varying refresh rates. The display array 30 may be segmented into regions of arbitrary shape and size, each region receiving video data with characteristics, such as refresh rate or compression encoding, specific only to that region. The regions may change video data characteristics and shape and size. The regions may be opened and closed and re-opened. Along with video data, the client device 7 can also receive control data. The control data can comprise commands from the server 2 to the client device 7 regarding, for example, video data characteristics such as compression encoding, refresh rate, and interlaced or progressively scanned video data. The control data may contain control instructions for segmentation of display array 30, as well as differing instructions for different regions of display array 30.

In one exemplary embodiment, the server 2 sends control and video data to a PDA via a wireless network 3 to produce a continuously updating clock in the upper right corner of the display array 30, a picture slideshow in the upper left corner of the display array 30, a periodically updating score of a ball game along a lower region of the display array 30, and a cloud shaped bubble reminder to buy bread continuously scrolling across the entire display array 30. The video data for the photo slideshow are downloaded and reside in the PDA memory, and they are in an interlaced format. The clock and the ball game video data stream text from the server 2. The reminder is text with a graphic and is in a progressively scanned format. It is appreciated that here presented is only an exemplary embodiment. Other embodiments are possible and are encompassed by state 86 and fall within the scope of this discussion.

Continuing to decision state 88, the client device 7 looks for a command from the server 2, such as a command to relocate a region of the display array 30, a command to change the refresh rate for a region of the display array 30, or a command to quit. Upon receiving a command from the server 2, the client device 7 proceeds to decision state 90, and determines whether or not the command received while at decision state 88 is a command to quit. If, while at decision state 90, the command received while at decision state 88 is determined to be a command to quit, the client device 7 continues to state 98, and stops execution of the application and resets. The client device 7 may also communicate status or other information to the server 2, and/or may receive such similar communications from the server 2. If, while at decision state 90, the command received from the server 2 while at decision state 88 is determined to not be a command to quit, the client device 7 proceeds back to state 86. If, while at decision state 88, a command from the server 2 is not received, the client device 7 advances to decision state 92, at which the client device 7 looks for a command from the user, such as a command to stop updating a region of the display array 30, or a command to quit. If, while at decision state 92, the client device 7 receives no command from the user, the client device 7 returns to decision state 88. If, while at decision state 92, a command from the user is received, the client device 7 proceeds to decision state 94, at which the client device 7 determines whether or not the command received in decision state 92 is a command to quit. If, while at decision state 94, the command from the user received while at decision state 92 is not a command to quit, the client device 7 proceeds from decision state 94 to state 96. At state 96 the client device 7 sends to the server 2 the user command received while at state 92, such as a command to stop updating a region of the display array 30, after which it returns to decision state 88. If, while at decision state 94, the command from the user received while at decision state 92 is determined to be a command to quit, the client device 7 continues to state 98, and stops execution of the application. The client device 7 may also communicate status or other information to the server 2, and/or may receive such similar communications from the server 2.

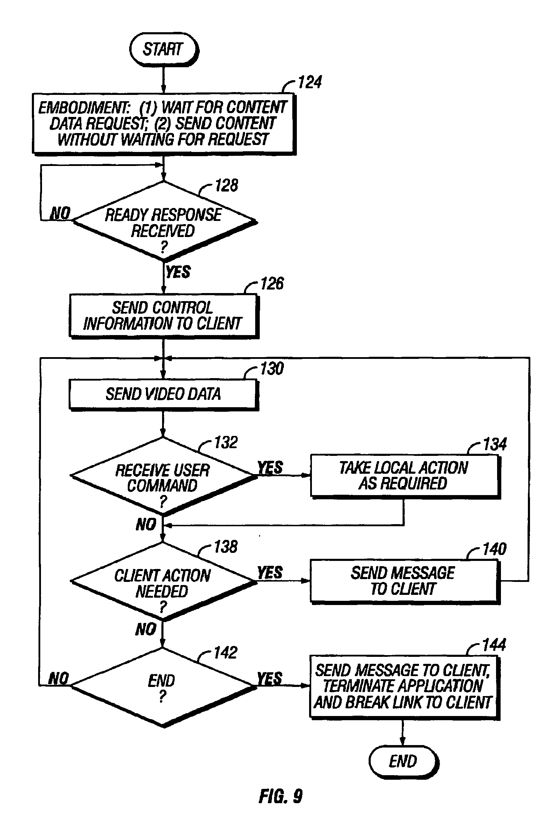

Figure 9 illustrates a control process by which the server 2 sends video data to the client device 7. The server 2 sends control information and video data to the client device 7 for display. Depending on the embodiment, states of Figure 9 can be removed, added, or rearranged.

Starting at state 124 the server 2, in embodiment (1), waits for a data request via the network 3 from the client device 7, and alternatively, in embodiment (2) the server 2 sends video data without waiting for a data request from the client device 7. The two embodiments encompass scenarios in which either the server 2 or the client device 7 may initiate requests for video data to be sent from the server 2 to the client device 7.

The server 2 continues to decision state 128, at which a determination is made as to whether or not a response from the client device 7 has been received indicating that the client device 7 is ready (ready indication signal). If, while at state 128, a ready indication signal is not received, the server 2 remains at decision state 128 until a ready indication signal is received.

Once a ready indication signal is received, the server 2 proceeds to state 126, at which the server 2 sends control data to the client device 7. The control data may stream from the server 2, or may be downloaded to the client device 7 memory for later access. The control data may segment the display array 30 into regions of arbitrary shape and size, and may define video data characteristics, such as refresh rate or interlaced format for a particular region or all regions. The control data may cause the regions to be opened or closed or re-opened.

Continuing to state 130, the server 2 sends video data. The video data may stream from the server 2, or may be downloaded to the client device 7 memory for later access. The video data can include motion images, or still images, textual or pictorial images. The video data can also have various compression encodings, and be interlaced or progressively scanned, and have various and varying refresh rates. Each region may receive video data with characteristics, such as refresh rate or compression encoding, specific only to that region.

The server 2 proceeds to decision state 132, at which the server 2 looks for a command from the user, such as a command to stop updating a region of the display array 30, to increase the refresh rate, or a command to quit. If, while at decision state 132, the server 2 receives a command from the user, the server 2 advances to state 134. At state 134 the server 2 executes the command received from the user at state 132, and then proceeds to decision state 138. If, while at decision state 132, the server 2 receives no command from the user, the server 2 advances to decision state 138.

At state 138 the server 2 determines whether or not action by the client device 7 is needed, such as an action to receive and store video data to be displayed later, to increase the data transfer rate, or to expect the next set of video data to be in interlaced format. If, while at decision state 138, the server 2 determines that an action by the client is needed, the server 2 advances to state 140, at which the server 2 sends a command to the client device 7 to take the action, after which the server 2 then proceeds to state 130. If, while at decision state 138, the server 2 determines that an action by the client is not needed, the server 2 advances to decision state 142.

Continuing at decision state 142, the server 2 determines whether or not to end data transfer. If, while at decision state 142, the server 2 determines to not end data transfer, server 2 returns to state 130. If, while at decision state 142, the server 2 determines to end data transfer, server 2 proceeds to state 144, at which the server 2 ends data transfer, and sends a quit message to the client. The server 2 may also communicate status or other information to the client device 7, and/or may receive such similar communications from the client device 7.

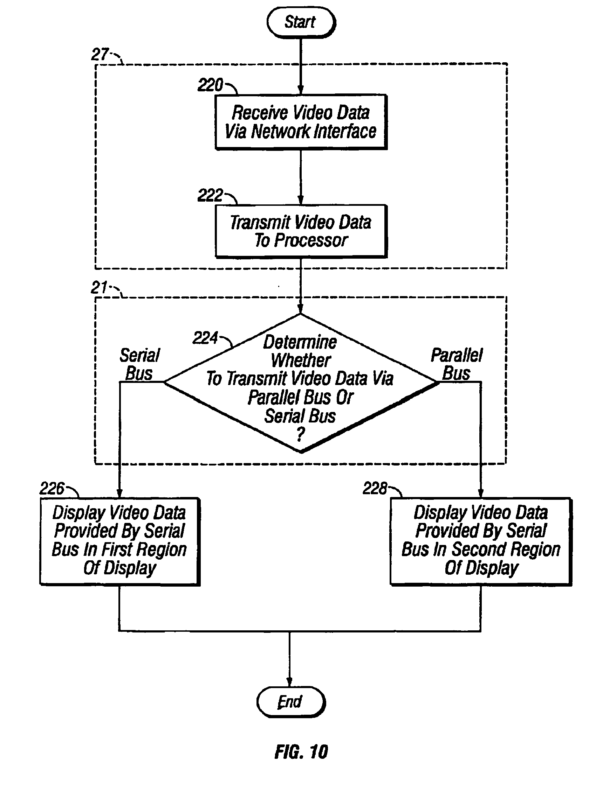

Figure 10 is a flowchart illustrating an exemplary method of receiving and processing data in the processor 21 of Figure 3A. Depending on the embodiment, additional states may be added, others removed, and the ordering of the states rearranged.

Starting at state 220, the network interface 27 receives video data. In one embodiment, the video data is received via the network 3 from the server 2. Continuing to state 222, the video data is transmitted to the processor 21. Next, at a decision state 224, the processor 21 determines whether to transmit the video data either via a parallel bus, e.g.., the data link 36, or a serial bus, e.g., the data link 31. If the determination is made to transmit the video data via the serial bus, the process proceeds to state 226. However, if the determination is made to transmit the video data via a parallel bus, the process proceeds to state 228.

In one embodiment, data that is transmitted via the data link 36 or the data link 31 is targeted for presentation on a particular region of the display area 30. The size, location, and refresh rate of each of the regions may be defined by the processor 21 (Figure 3A), the server 2 (Figure 1), or another device or component. Furthermore, each of the particular regions of the display array 30 associated with the data link 36 and the data link 31 may be overlapping or coextensive.

In one embodiment, the data link 31 is used to provide, in addition to or in lieu of the video data, control data to the array driver 22. The control data can include information defining the regions of the display area 30, the refresh rates of the regions of the display array 30, frame skip count information, etc. Furthermore, in one embodiment, the data link 31 is used to transmit executable code defining a drive scheme for the display area 30. This advantageously allows legacy driver controllers to be used in systems that provide the drive and display schemes discussed above. At state 226 (serial bus path), the array driver 22 displays the video data provided by the serial bus in a first region of the display array 30. At state 228 (parallel bus path), the array driver 22 display the video data provided via the parallel bus and the driver controller 29 in a second region in the display array 30.

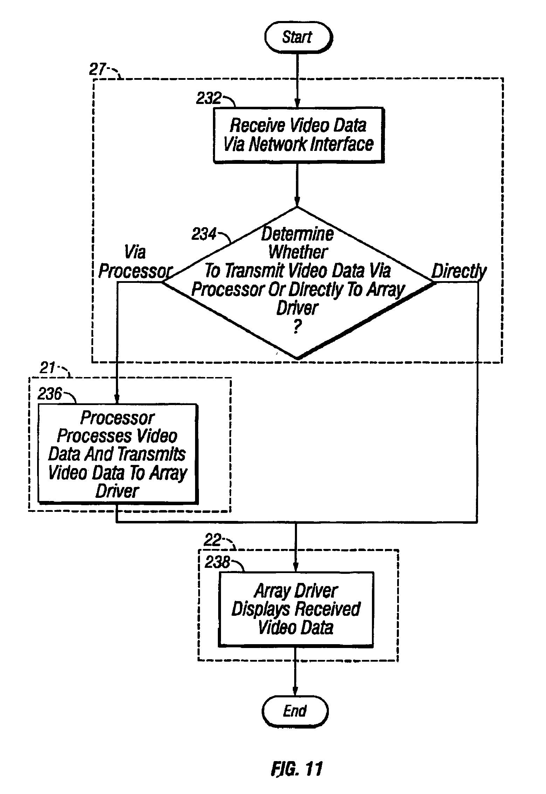

Figure 11 is a flowchart illustrating an exemplary method of receiving and processing data in the network interface 27 of Figure 3A. In this exemplary embodiment, data is received by the network interface 27 and it is determined whether the data should be routed to the processor 21 or the array driver 22. Depending on the embodiment, additional states may be added, others removed, and the ordering of the states rearranged.

Starting at state 232, the network interface 27 receives video data from the network 3. In one embodiment, the video data is received via the network 3 (Figure 1) from the server 2 (Figure 1).

Continuing to a decision state 234, the network interface 27 determines whether to transmit the video data either over the data link 33 directly to the array driver 22 or, alternatively, directly to the processor 21. In one embodiment, the determination is made based upon control information associated with or part of the received video data. For example, a header in the received video may indicate that the video is to be transmitted via the data link 33 to be displayed, in a selected region on the display array, and to be updated using a selected refresh rate.

If the determination is made to transmit the video data to the processor 21, the method proceeds to state 236. However, if the determination is made to transmit the video data to the array driver 30, the process proceeds to state 238.

In one embodiment, data that is transmitted directly to the display array via the data link 33 is targeted for presentation on a particular region of the display area 30. The size, location, and refresh rate of each of the regions may be defined by the processor 21 (Figure 3A), the server 2 (Figure 2), or another device or component. Furthermore, each of the particular regions of the display array 30 associated with data received via data link 33 and from the processor 21 may be overlapping or coextensive.

In one embodiment, the data link 33 is used to provide, in addition to or in lieu of the video data, control data to the array driver 22. The control data can include information defining the regions of the display area 30, the refresh rates of the display area 30, frame skip count information, etc. Furthermore, in one embodiment, the data link 33 is used to transmit executable code defining a drive scheme for the display area 30. This advantageously allows legacy processors, software, and driver controllers to be used in systems that provide the drive and display schemes discussed above. At state 238 (from either the state 234 or 236), the array driver 22 displays the video data provided.

While the above detailed description has shown, described, and pointed out novel features as applied to various embodiments, it will be understood that various omissions, substitutions, and changes in the form and details of the device or process illustrated may be made by those skilled in the art without departing from the spirit of the invention. As will be recognized, the present invention may be embodied within a form that does not provide all of the features and benefits set forth herein, as some features may be used or practiced separately from others.

## Claims

1. A system, for displaying video data, the system comprising:
means for receiving video data from a network; and
means for determining whether to transmit the video data to an array driver or to a processor.

2. The system of Claim 1, wherein the receiving means comprises a receiver.

3. The system of Claims 1 or 2, wherein the determining means comprises a network interface.

4. The system of Claim 1, wherein the determining means additionally comprises reading control information in the video data.

5. The system of Claim 4, additionally comprising means for transmitting the video data to at least one of the array driver and the processor based on said determining means.

6. The system of Claim 5, wherein the transmitting means comprises a bus.

7. The system of Claim 6, wherein the bus is either serial or parallel.

8. The system of Claim 5, additionally comprising means for displaying the video data.

9. The system of Claim 8, wherein the displaying means comprises bi-stable display elements.

10. The system of Claim 9, wherein the bi-stable display elements are logically partitioned into at least a first group of bi-stable display elements and a second group of bi-stable display elements, and wherein the displaying means additionally comprises selecting a group of the bi-stable display elements based on the control information in the video data.

11. The system of Claim 10, wherein said transmitting means transmits the video data to the array driver, said displaying means displays the video data on the first group, and wherein said transmitting means transmits the video data to the processor, said displaying means displays the video data on the second group.

12. The system of Claim 8, wherein the control information defines a refresh rate of the bi-stable display elements.

13. The system of Claim 10, wherein the control information defines an interlace or progressive display mode of the logical partition of the first group of bi-stable display elements or the second group of bi-stable display elements.

14. The system of Claim 1, additionally comprising:
a display;
a processor that is in electrical communication with said display, said processor being configured to process image data; and
a memory device in electrical communication with said processor.

15. The system of claim 14, further comprising a driver circuit configured to send at least one signal to said display.

16. The system of claim 15, further comprising a controller configured to send at least a portion of an image data to said driver circuit.

17. The system of Claim 14, further comprising an image source module configured to send said image data to said processor.

18. The system of Claim 17, wherein said image source module comprises at least one of a receiver, transceiver, and transmitter.

19. The system of Claim 14, further comprising an input device configured to receive input data and to communicate said input data to said processor.

20. A method of displaying video data, the method comprising:
receiving, in an electronic device, video data from a network; and
determining whether to transmit the video data directly to an array driver or to a processor.

21. The method of Claim 20, wherein determining whether to transmit video data directly to the array driver or the processor comprises reading control information in the video data specifying a transmission route.

22. The method of Claim 20, additionally comprising transmitting the video data directly to the array driver.

23. The method of Claim 22, wherein the transmitting is independent of the processor.

24. The method of Claim 20, additionally comprising transmitting the video data directly to the processor.

25. The method of Claim 20, additionally comprising receiving control information defining a communication route.

26. A method of manufacturing a display system, comprising:
providing an array of bi-stable display elements, the array being logically partitioned into at least a first group of bi-stable display elements and a second group of bi-stable display elements;
connecting an array driver, to the array, the array driver being configured to control the bi-stable display elements;
providing a central processing unit that is configured to transmit video data to the array driver for display via the first group of bi-stable display elements; and
providing a network interface that is configured to receive video data and control information, the network interface being configured to determine, based upon the control information, whether to transmit the video data to the array driver for display or to the central processing unit, wherein the video data that is transmitted to the array driver directly from the network interface is displayed via the second group of bi-stable display elements.

27. A display manufactured by the method of Claim 26.
